# EUROPEAN PATENT SPECIFICATION

(11) **EP 4 764 454 B1**
(45) Date of publication and mention of the grant of the patent: **04.11.2026**
(21) Application number: 24221251.2
(22) Date of filing: 18.12.2024
(51) Int. Cl.: G01N 21/03, G01N 21/3504, H01S 5/02253, H01S 5/00, H01S 5/02257

(54) **DEVICE, SYSTEM AND METHOD FOR OPTICAL GAS ANALYSIS**
VORRICHTUNG, SYSTEM UND VERFAHREN ZUR OPTISCHEN GASANALYSE
DISPOSITIF, SYSTÈME ET PROCÉDÉ D'ANALYSE OPTIQUE DE GAZ

(43) Date of publication of application: 24.06.2026
(73) Proprietor: Axetris AG, 6056 Kägiswil (CH)
(72) Inventor: Wittmann, Andreas, 6074 Giswil (CH); Schlesinger, Sven, 6072 Sachseln (CH)
(74) Representative: Witte, Weller & Partner Patentanwälte mbB

(56) References cited:
- EP-A1- 3 176 564
- WO-A1-2024/201074
- US-A1- 2006 083 283
- US-A1- 2010 002 235
- US-A1- 2013 070 797
- US-A1- 2022 397 518

## Description

### FIELD OF THE INVENTION

The present invention relates to a device for optical gas analysis. The present invention furthermore relates to a corresponding system and method for optical gas analysis.

### BACKGROUND OF THE INVENTION

Optical gas analyzers can use the absorption of light by a gas to determine the concentration of the gas. A measurement gas may also comprise a combination of one or more different gases. Gas analyzers can be used for several applications, for example in industry, for environmental monitoring, and/or for medical applications.

Several gases absorb light in several narrow absorption lines or, in case of larger molecules, in absorption bands. The spectral position of absorption lines or bands is characteristic of each gas. Therefore, it is often possible to identify gases based on their absorption lines or bands. The proportion of light absorbed by a gas depends on the gas itself, on the gas concentration and on the optical path length where light can be absorbed. The Beer-Lambert or Lambert-Beer law is commonly applied to chemical analysis measurements to determine the concentration of chemical species that absorb light. The Beer-Lambert law can thus provide a simplified model by: $I \left(c, λ\right) = {I}_{0} {e}^{- α \left(λ, c\right) L}$ $α \left(λ, c\right) = ϵ \left(λ\right) c ,$ where *I* is the light at wavelength *λ* transmitted through the gas cell, *I₀* is the light intensity at wavelength *λ* before the gas cell, *c* is the gas concentration by volume, *a*(*λ*,*c*) is the absorption coefficient of the gas and *L* is the optical path length. Knowing the proportion of light absorbed, the wavelength, the specific absorptivity of the gas *ε*(*λ*), and the optical path length it is possible to determine the gas concentration.

Although the fundamental principle is known in the art, a multitude of different practical realizations exist to determine gas concentrations by optical measurements. Exemplary measurement principles of different gas analyzers are Direct Absorption Spectroscopy (DAS) and Wavelength Modulation Spectroscopy (WMS).

Direct Absorption Spectroscopy (DAS) is a widely used technique for measuring the concentration of gases by monitoring how much light a sample absorbs at specific wavelengths. In DAS, a laser or other light source is tuned to a specific wavelength, which corresponds to a characteristic absorption line of the gas of interest. The light passes through the sample, and the decrease in intensity due to absorption by the gas molecules is measured. This reduction in intensity, often described by Beer-Lambert's law as indicated above, is directly related to the concentration of the absorbing species. By precisely measuring the transmitted light and comparing it to the incident light, the gas concentration can be determined. Despite its simplicity and broad applicability, DAS can be susceptible to issues like baseline drift, electronic noise, and background interferences, making it less sensitive for detecting low-concentration species.

Wavelength Modulation Spectroscopy (WMS) is a more advanced technique that can improve the sensitivity and signal-to-noise ratio of traditional absorption measurements, especially for detecting trace gases. In WMS, instead of measuring absorption at a fixed wavelength, the wavelength of the light source, usually a laser, is modulated at high frequency around a central wavelength of a gas absorption line. This modulation shifts the measurement signal to higher frequencies, away from low-frequency noise and baseline fluctuations that commonly affect Direct Absorption Spectroscopy (DAS). The detected signal is then demodulated at specific harmonics, often the second harmonic, of the modulation frequency, which provides a much clearer indication of the absorption features. This process not only enhances the ability to detect weak absorption signals, even in the presence of noise, but also allows for improved resolution and sensitivity, making WMS a preferred method in applications requiring high precision, such as atmospheric monitoring, industrial gas detection or medical applications.

In US 8,594,143 B2, it was recognized that the measurement performance may be impaired by changing interference patterns that are caused by temperature influences on or in the housing of the laser diode structure. US 8,594,143 B2 suggests to provide a laser diode structure with integrated temperature-controlled beam shaping element and method for gas detection by means of a laser diode structure. In particular, the disclosure relates to laser diode structure, specifically for use in gas detection, with a hermetically sealed housing with electrical connections having a bottom and a window. A laser diode chip and a temperature control system for the laser diode chip are provided in the housing. A thermo element, for example a Peltier element with a thermistor, forms the temperature control system, and is connected via a lower flat surface to the bottom of the housing and via an upper flat surface to the laser diode chip, with a temperature-controlled beam shaping element as a collimator provided between the laser diode chip and the window of the housing that acts on a laser beam emerging from a laser aperture of the laser diode chip before it passes through the window. The beam shaping element is in contact with the laser diode chip and is preferably connected via a boundary surface to the laser aperture with surface-to-surface contact or adhesively, or is made in one piece together with the laser aperture. Hence, a fully temperature-controlled beam-shaping is provided in US 8,594,143 B2. The sensitivity of a gas sensor can thus be improved by avoiding temperature dependent interference phenomena.

US 9,377,359 B1 relates to an optical measuring system and a method for gas detection, the optical measuring system including a light emitter and at least one light detector arranged in at least one housing, wherein the light emitter emits a modulated main light beam with a mean wavelength λ0 with a modulation span Δλ. At least one opto-mechanical component, e.g. a housing window including optically effective boundary surfaces, is arranged between the light emitter and the light detector and causes scatter light beams which interfere with the main light beam so that self-mixing occurs and/or etalons are caused. According to the disclosure the at least one opto-mechanical component is arranged relative to the light emitter and/or the light detector at an optimized distance L which is a function of the wavelength λ0 and the modulation span Δλ of the main light beam. The disclosure is based on the idea to use a particularity of the wave length modulation spectroscopy method (WMS) in order to adapt interferences in the measuring signal of the light detector using an adaptation of the distances in the measuring system upon the modulation span of the light emitter so that interferences in the measuring signal of the light detector are not transferred into the demodulated signal, e.g. into the 2f signal, in order to reduce interferences in the gas measurement. Through an intelligent choice of the distance in the measuring system, thus in principle all dominant interferences in the demodulated measuring signal can be suppressed or at least reduced. The relation between a residual interference over distance can be expressed by an interference filter curve, as exemplarily shown in Fig. 4 of US 9,377,359 B1, that illustrates the amplitude of the interfering signals in the detection signal (output of lock-in detector) with reference to the distance determining the optical path length difference at a modulation of the main light beam. A drawback of this approach is that the interference mitigation is very susceptible to optical path length differences.

US 2006/083283 A1 discloses a surface-emitting laser light source comprising a micro-lens formed from semiconductor material and mounted directly over the emitter. The purpose of this integrated micro-lens is to reduce the laser emission angle.

US 2013/070797 A1 discloses a laser unit wherein a micro-lens, such as a ball lens, is mounted over the laser chip aperture using an optical medium such as an index-matching adhesive.

In order to obtain a high sensitivity, in particular for gas sensing applications that target the ppb-region (parts per billion), the straightforward approach is to perform the measurement by probing the fundamental absorption lines of the measurement gases, i.e. in a spectral region where the strongest signal is expected. However a drawback is that in many cases this requires rather expensive mid-IR lasers.

### SUMMARY OF THE INVENTION

It is an object of aspects of the present invention to provide a further improved device, system and method for optical gas analysis. In particular, it would be desirable to further improve a measurement accuracy and/or sensitivity, while at the same time allowing reasonable costs.

The claimed subject matter is defined in the appended independent claims. Further refinements are provided in the dependent claims.

In a first aspect of the present invention a device for optical gas analysis is presented, the device comprising: a gas cell for a measurement gas; a light source adapted to emit light into the gas cell; a light detector adapted (and arranged) to receive the light after passing through the measurement gas in the gas cell; wherein the light source comprises an emitter, a first optical element and a second optical element; wherein the first optical element is a micro-lens mounted directly over an aperture of the emitter and adapted to reduce a divergence angle of light emitted by the emitter to provide pre-collimated light; wherein the second optical element is adapted to receive the pre-collimated light from the micro-lens and to shape a light beam for emission into the gas cell, wherein a ratio of the focal length f₂ of the second optical element to a focal length f₁ of the first optical element, f₂/f₁, is at least 20.

In a further aspect of the present invention a system for optical gas analysis is presented, system comprising: a device as described herein; and an analyzer, wherein the analyzer is adapted to determine at least one gas concentration of at least one component of the measurement gas based on the light detected by the light detector.

In yet a further aspect of the present invention, a method for optical gas analysis is presented, the method comprising the steps of: providing a gas cell with a measurement gas; emitting light from a light source into the gas cell; and detecting the light after passing through the measurement gas in the gas cell; determining at least one gas concentration of at least one component of the measurement gas based on the detected light; wherein the light source comprises an emitter, a first optical element and a second optical element; wherein the first optical element is a micro-lens mounted directly over an aperture of the emitter and adapted to reduce a divergence angle of light emitted by the emitter to provide pre-collimated light; wherein the second optical element is adapted to receive the pre-collimated light from the micro-lens and to shape a light beam for emission into the gas cell, wherein a ratio of the focal length f₂ of the second optical element to a focal length f₁ of the first optical element, f₂/f₁, is at least 20.

Preferred embodiments of the invention are defined in the dependent claims. It shall be understood that the claimed method and system can have similar and/or identical preferred embodiments as the claimed device for optical gas analysis, in particular as defined in the dependent claims and as disclosed herein.

Aspects of the present invention are based on the idea of providing a device for optical gas analysis with a specifically modified light source arrangement. At first glance it may seem counterintuitive for the skilled person to use the more complex combination of a first optical element and a second optical element as defined in claim 1 in the specific case of a device for optical gas analysis, since it would at first glance be sufficient and more cost efficient to provide a single proper collimating lens. Furthermore, additional optical elements with additional optical surfaces may lead to additional sources of additional disturbances.

However, the inventors recognized that in order to provide sufficient optical power, such a lens may - at least for certain wavelengths and modulation spans in Wavelength Modulation Spectroscopy (WMS) - have a thickness lying in a range wherein the front and back surfaces of the lens can lead to disturbances in trace gas measurement due to etalon effects that lie in the typical range of gas peaks to be analyzed. Disturbances from the front surface and disturbances from the back surface may occur which do not allow for cancellation in signal processing. Moreover, such a lens may surprisingly have a diameter, wherein a path length difference of a chief ray and a marginal ray from the light source to the lens may also not allow for cancellation of disturbances in the signal processing in view of the different path lengths onto different portions of the lens.

It is thus suggested to provide a device for optical gas analysis with an emitter having a first optical element and a second optical element having greatly differing focal lengths. The device comprises a combination of a first optical element, the optical power of which alone would not be sufficient, in combination with the proposed second optical element, wherein the focal length of the second optical element is much longer than the focal length of the first optical element. The first optical element having the shorter focal length is a micro-lens mounted directly over an aperture of the emitter. Negative impact of residual optical interference fringes from the first optical element is suppressed by a very short focal length that ensures that residual optical noise exhibits a very long free-spectral range that can be well distinguished from the absorption signal. Moreover, this specific configuration overcomes the problem of a chief and marginal ray having substantially different path lengths such that residual disturbances cannot be cancelled in the signal processing. Since the second optical element having the much longer focal length is provided with pre-collimated light from the micro-lens and thus reduces a path length difference between the chief and marginal ray, interference mitigation in signal processing and adapting the (frequency) modulation depth of the emitter and the position of the second optical element with respect to each other becomes possible. The specific combination of a micro-lens mounted directly over an aperture of the emitter and adapted to provide pre-collimated light in combination with a second optical element, wherein the ratio of the focal length f₂ of the second optical element to the focal length f₁ of the first optical element, f₂/f₁, of at least 20 can thus help to further improve the performance of devices for optical gas analysis.

A further advantage of the proposed solution can be that the residual noise in a device for optical gas analysis can be further reduced while at the same time allowing the realization of longer optical path lengths in a gas cell. The second optical element having the much longer focal length allows to provide a better collimation, e.g. compared with a single ball lens, and thus to further reduce a divergence angle of the light beam for emission into the gas cell. A light beam with reduced divergence enables longer path lengths through the measurement gas in the gas cell, e.g. using a multi-pass cell. A longer optical path length increases the sensitivity. It was found that even though the proposed solution with the second optical element adds another surface in the beam path that can lead to interference noise, the optical path length can be increased by such an extent that the sensitivity advantage due to the path length increase can overcompensate the added interference noise. In particular, the sensitivity for measurements of low gas concentrations can be improved to such an extent that even overtone absorption lines or side peaks of a measurement gas may be evaluated with a less expensive near-IR light source at IR wavelengths instead of using a costly mid-IR light source tailored for a main or fundamental absorption line in the mid-IR. An advantage can thus be a lower overall system cost because no expensive mid-IR laser source may be required to reach a high sensitivity.

In the following, some terms which are used throughout the application, shall be shortly explained and defined. The term "gas cell" can refer to a measurement volume for a measurement gas. A gas cell can have different shapes. For example, a cylindrical gas cell may be provided with an inlet and an outlet for the measurement gas to be analyzed. The term "measurement gas" can refer to a measurement gas comprising a one or more gases to be analyzed, in particular to a mixture wherein the system for optical gas analysis may be used for determining the constituents and/or concentrations.

In an embodiment, the light source comprises no further beam shaping optical elements besides the first and second optical element. In other words, the beam shaping optical elements of the light source consist of the first and second optical element. An advantage can be a cost-efficient implementation. Moreover, the number of surfaces that may lead to disturbances such as interference effects can be reduced. Nonetheless, additional surfaces such as entrance and exit windows / wedges for a gas cell or an optional alignment mirror may still be present.

The emitter can be a NIR (near-infrared), IR (infrared) or MIR (mid-infrared) emitter, in particular a laser adapted to emit light in the near-infrared, infrared or midinfrared region. As used herein, NIR can refer to a wavelength range of 750 nm to 2.5 µm, MIR can refer to a wavelength range of 2.5 µm to 25 µm; and the more general term IR can refer to a wavelength range of 750 nm to 1 mm. In a refinement, the emitter can be adapted to emit light at a wavelength in a wavelength range between 1.3 µm to 2.1 µm. An advantage of using a NIR laser can be a cost efficient implementation as well as good availability of light sources at different wavelengths and over a broad range of optical powers. Moreover, such light sources are well suited for Wavelength Modulation Spectroscopy (WMS).

As used herein, a micro-lens can refer to a miniature lens that is directly mounted over an aperture of the emitter. In particular, the micro-lens may be directly attached to a semiconductor chip. It is also possible that the micro-lens is structured into a chip surface. The micro-lens may be a beam-shaping element as described in US 8,594,143 B2, as cited above.

The light beam emitted into the gas cell from the second optical element may also be referred to as a measurement beam or measurement light beam. It can be a collimated beam or a focused beam. The second optical element can be adapted to shape the measurement light beam as a collimated beam having a divergence angle of no more than 0.2°, in particular of no more than 0.15°, in particular of no more than 0.1°, in particular of no more than 0.05°. As used herein, the divergence angle refers to a half-angle, in particular a half-angle or half-width at half-max (HWHM), for example of a Gaussian beam profile.

In a further refinement the ratio of the focal length f₂ of the second optical element to a focal length f₁ of the first optical element, f₂/f₁, can be at least 35, in particular at least 50, in particular at least 100, in particular at least 150. An advantage of this embodiment is that a substantial pre-collimation is provided by the first optical element and a size and/or thickness of the second optical element may only result in limited residual interference effects due to different path lengths of a chief and marginal ray and/or due to reflections at a front and back surface of a lens as the second optical element.

The micro-lens can be adapted to reduce a divergence angle of the light emitted by the emitter by at least 70 %, in particular by at least 80 %, in particular by at least 90 %. It is thus suggested to provide a certain amount of pre-collimation such that a size and/or thickness of the second optical element may be reduced to reduce interference effects.

The first focal length f₁ of the micro-lens can be smaller than 0.8 mm, in particular smaller than 0.6 mm, in particular smaller than 0.4 mm, in particular smaller than 0.3 mm, in particular smaller than 0.2 mm. In addition or in the alternative, the second focal length of the second optical element can be at least 10 mm, in particular at least 20 mm, in particular at least 30 mm, in particular at least 50 mm. An advantage can be that a compact design of the light source can be implemented while still providing a measurement light beam sufficient for low-concentration gas sensing. It shall be understood that the focal lengths as used herein refer to a focal length measured with respect to a refractive index n=1. Nonetheless, the micro-lens may be applied to the emitter in an index-matching manner, for example using index-matching glue.

The second optical element in the device for optical gas analysis can be an optical thin lens. In optics, a thin lens can refer to a lens with a thickness (distance along the optical axis between the two surfaces of the lens) that is negligible compared to the radii of curvature of the lens surfaces. More precisely, a thin lens as used herein can refer to a lens having a thickness such that both the front surface and the back surface of the lens are at a distance in proximity of an interference minimum of an interference filter curve, e.g. of a 2f signal. Further details regarding an interference minimum of a 2f signal and regarding an interference filter curve are described in the aforementioned US 9,377,359 B1. A distance of the front and/or back surface of the lens to a minimum of the interference filter curve may be no more than 30%, in particular no more than 20%, in particular no more than 10% of a separation between neighboring interference minima in the interference filter curve. Interference effects can be reduced significantly, since with the proposed solution both surfaces e.g. of the second optical element can be placed in close proximity of a distance at an interference minimum. It is thus suggested to provide a thin lens, the optical power of which alone would not be sufficient but with a thickness not giving rise to disturbances due to the separation of its front and back surface in optical trace gas measurement, in combination with the proposed first optical element.

It is also possible that the second optical element in the device for optical gas analysis can be a mirror, in particular an off-axis parabolic (OAP) mirror. An advantage can be that residual disturbances can be further reduced since there is only one optical surface rather than a front and back surface of a lens that may lead to disturbances in trace gas measurement. Moreover, in combination with the pre-collimation provided by the micro-lens a path length difference between the marginal rays is substantially reduced such that residual interferences can be reduced. Advantages of this embodiment can comprise one or more of a low divergence angle, low spherical aberrations and reduced stray light thanks to the off-axis configuration. While conventional OAP mirrors may be prohibitively expensive, the proposed combination with pre-collimation by the micro-lens makes it possible that a much smaller and thus cheaper OAP mirror can be used.

In a further refinement, the mirror can be an adjustable mirror for adjusting a direction of the light beam for emission into the gas cell. Optionally, a separate mirror can be provided for adjusting a direction of the light beam for emission into the gas cell can be provided. An advantage of a separate mirror is that it can also be used with a lens as the second optical element. However, an additional synergistic effect can be reached if the second optical element is not only configured to provide the respective ratio of focal lengths but is further configured for adjusting the direction of the measurement light beam. For example, the number of passes in a multi-pass gas cell may be altered by adjusting the direction under which the light beam enters the gas cell. A position and/or tilt angle of the mirror may be adjustable.

The micro-lens may be applied to the emitter in an index-matching manner, for example using index-matching glue. In a refinement, the micro-lens may be a ball lens mounted directly over the aperture of the emitter with index-matching glue, wherein a refractive index of the index matching glue matches a refractive index of the micro-lens. An advantage of this embodiment can be that there is one surface less that may cause disturbances.

In an advantageous refinement, the micro-lens can be mounted directly over the aperture of the emitter in an index-matching manner and the second optical element can be a mirror. Advantageously, the optical system of the emitter for providing the light beam for emission into the gas cell is thus defined by only two beam shaping surfaces. If the micro-lens is mounted in an index-matching manner, for example if the micro-lens is glued with an index matching glue to the aperture of the emitter, only the rear or outer surface of the micro-lens is beam shaping. If the second beam shaping element is realized as a mirror, there is just one surface compared with a lens, having two surfaces. Accordingly, potential error sources leading to interference effects can be further reduced.

The light emitter and the first optical element can be arranged in a common light emitter housing. The light emitter housing can comprise an exit window for the pre-collimated light. The exit window can be arranged in a light path between the first optical element and the second optical element. The exit window may be tilted with respect to an optical axis such that back-reflections are deflected from the emitter. The exit window may also be arranged at a distance corresponding to a minimum of the interference filter curve.

Similar to tilting the exit window, it is also possible that the second optical element is tilted with respect to an optical axis such that back-reflections are deflected from the emitter. Thereby, interference artifacts can be reduced.

A position of the second optical element with respect to the light emitter can be adapted to reduce an interference caused by an optical surface of the second optical element on the light emitter. In particular, the second beam shaping element can be placed at a location that results in a minimum of residual interference. In addition or in the alternative, a position of the second optical element with respect to the light detector can be adapted to reduce (in particular to minimize) a (residual) interference caused by an optical surface of the second optical element to the light detector.

The light emitter can be configured to emit light with a center wavelength λ0 and a modulation span (sometimes referred to as modulation amplitude) Δλ. A distance between the second optical element and the light emitter and/or the light detector and the modulation span Δλ can be adapted with respect to each other such that a disturbance caused by an optical surface of the second optical element on a demodulated measurement signal is minimized.

The gas cell can be a multi-pass gas cell, in particular a multi-pass gas cell adapted to provide an optical path length of at least 5 m, in particular of at least 10 m, in particular of at least 20 m. The optical path length of the measurement beam through measurement gas can thus be enhanced. An advantage of this embodiment can be an improved measurement sensitivity. The specific combination of the first and second optical element as described herein has been found to allow longer path lengths than prior art solutions.

### BRIEF DESCRIPTION OF THE DRAWINGS

These and other aspects of the invention will be apparent from and elucidated with reference to the embodiment(s) described hereinafter. In the following drawings:
- Fig. 1: shows a schematic diagram of a system for optical gas analysis with a device according to an aspect of the present disclosure;
- Fig. 2: shows a schematic diagram of a first embodiment of a light source of a device for optical gas analysis according to an aspect of the present disclosure;
- Fig. 3: shows a schematic diagram of a further light source;
- Fig. 4: shows a schematic diagram of a second embodiment of a light source of a device for optical gas analysis according to an aspect of the present disclosure;
- Fig. 5: shows a diagram illustrating an interference filter curve indicative of a noise contribution by direct feedback;
- Fig. 6: shows a diagram illustrating an interference filter curve indicative of a noise contribution due to lens thickness;
- Fig. 7: shows a flow chart of a method according to an aspect of the present disclosure.

### DETAILED DESCRIPTION OF THE INVENTION

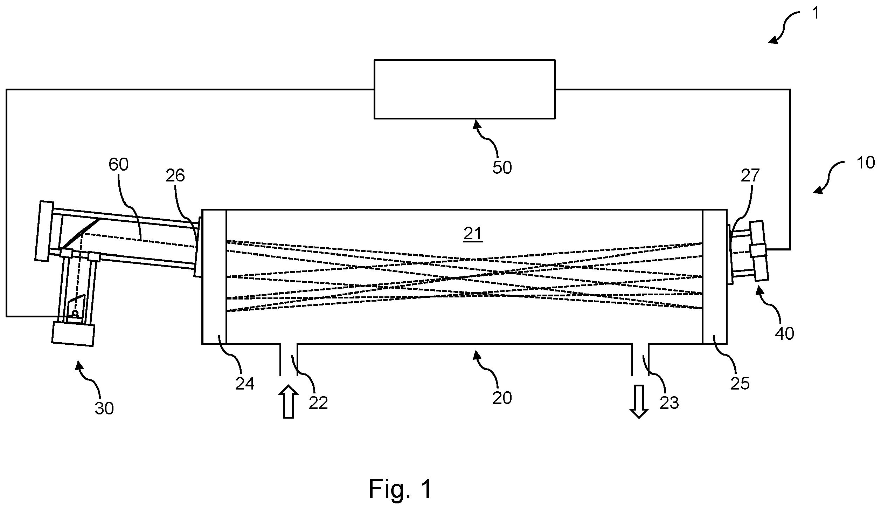

Fig. 1 schematically shows an embodiment of a system for optical gas analysis according to an aspect of the present disclosure. The system is therein denoted in its entirety by reference numeral 1. The system 1 comprises a device for optical gas analysis 10 and an analyzer 50. The device 10 comprises a gas cell 20 for a measurement gas 21, a light source 30 adapted to emit light into the gas cell, and a light detector 40 adapted to receive the light after passing through the measurement gas in the gas cell. The analyzer 50 is adapted to determine at least one gas concentration of at least one component of the measurement gas 21 based on the light detected by the light detector 40. As shown in Fig. 1, the analyzer 50 is coupled to the light detector 40 and may also be coupled to the light source 30. The analyzer 50 can be adapted to control the light source 30 for the desired measurement task. For example, the system 1 may be a TDLAS, Tunable Diode Laser Absorption Spectroscopy, system, in particular a system adapted to perform Wavelength Modulation Spectroscopy (WMS).

The gas cell 20, also referred to as absorption cell, may comprise one or more gas connectors to allow gas exchange in the gas cell. In the example shown, an inlet 22 and an outlet 23 are provided for the measurement gas. The measurement gas 21 can thus be introduced into the gas cell 20 via the inlet 22 and leave the gas cell via the outlet 23. The gas cell 20 may be filled with a measurement gas to be analyzed. However, it is also possible to provide a gas flow that flows from the inlet 22 to the outlet 23 so that the gas flow can be analyzed continuously. The inlet 22 and the outlet 23 may also be arranged at different positions, for example on opposite side walls of the gas cell 20 such that the measurement gas 21 passes through the gas cell 20.

As exemplarily shown in Fig. 1, the gas cell 20 can be a multi-pass gas cell such as a Pfund cell, a White cell or a Herriott cell. The gas cell 20 can comprise a first mirror 24 and a second mirror 25 on opposite sides such that the light beam 60 emitted into the gas cell 20 is reflected multiple times and performs multiple passes through the measurement gas 21 before reaching the light detector 40. The gas cell can comprise an entrance opening or entrance wedge or window 26 for receiving light from the light source 30 and an exit opening or exit window 27 for proving light to the light detector 40. The gas cell 20 can be adapted to provide an optical path length of at least 5 m, in particular of at least 10 m, in particular of at least 20 m. The gas cell 20 can thus provide a long optical path length through the measurement gas 21, such that a trace gas measurement with high sensitivity can be provided. However, a longer optical path length requires a collimated or focused laser beam.

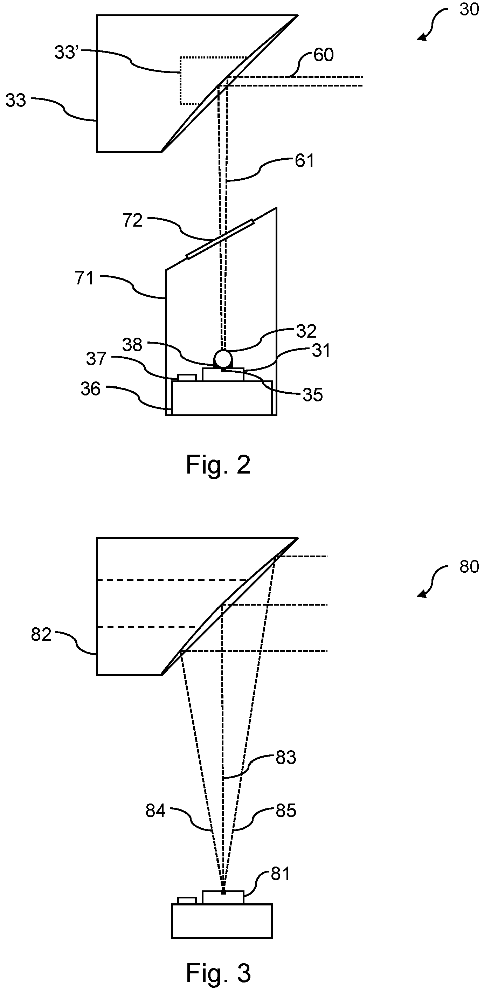

Fig. 2 shows an exemplary embodiment of a light source 30 of a device 10 for optical gas analysis. The light source 30 of Fig. 2 may for example be used in a system as shown in Fig. 1. The light source 30 comprises an emitter 31, a first optical element 32 and a second optical element 33. The first optical element 32 is a micro-lens mounted directly over an aperture 35 of the emitter 31 and adapted to reduce a divergence angle of light emitted by the emitter to provide pre-collimated light 61. The second optical element 33 is adapted to receive the pre-collimated light 61 from the micro-lens and to shape a light beam 60 for emission into the gas cell, wherein a ratio of the focal length f₂ of the second optical element 33 to a focal length f₁ of the first optical element 32, f₂/f₁, is at least 20. In the shown embodiment, the light source 30 comprises no further beam shaping optical elements besides the first and second optical element 32, 33. In other words, the beam shaping optical elements of the light source consist of the first and second optical element as the two beam shaping elements.

In the exemplary embodiment shown in Fig. 2, the emitter 31 adapted to emit light via the aperture 35 can be mounted on a temperature-controlled element 36 such as a Peltier element. A thermistor 37 may be provided for controlling the temperature. Preferably, the first optical element 32 is also in thermal contact with the temperature-controlled element 36, either directly or indirectly via the emitter 31. This allows "freezing" of interference fringes. In the example shown in Fig. 2, the second optical element 33, is not temperature controlled.

The light emitter 31 and the first optical element 32 can be arranged in a common light emitter housing 71. The light emitter housing 71 can comprise an exit window 72 for the pre-collimated light 61. The exit window 72 can be arranged in a light path between the first optical element 32 and the second optical element 33. The exit window 72 may be tilted with respect to an optical axis, e.g. of the pre-collimated light, such that back-reflections are deflected from the emitter 31. The exit window 72 may also be referred to as a laser cap window. The exit window 72 may also be arranged at a distance corresponding to an interference minimum of an interference filter curve, as will be described further below.

The micro-lens may be applied to the emitter 31 in an index-matching manner, for example using index-matching glue 38. In a refinement, the micro-lens may be a ball lens mounted directly over the aperture 35 of the emitter 31 with index-matching glue, wherein a refractive index of the index matching glue matches a refractive index of the micro-lens. Accordingly there is one surface less that may cause disturbances.

In a further refinement of the exemplary embodiment shown in Fig. 2, the first beam shaping or optical element 32 is a ball lens (for example having a diameter <300 µm) that is glued with an index-matching glue to the emitter 31. The short focal length f₁ of the ball lens allows a very short working distance (approx. 100um). Note, that just the outer side of the ball lens (away from the laser) acts as a beam shaping surface.

The first optical element 32 as a micro-lens, here a ball lens, being mounted directly over the aperture 35 of the emitter 31 advantageously results in very low interference noise. Residual interferences between laser and surfaces of lens result in a long free-spectral range ( $FSR ∝ \frac{{λ}^{2}}{2 n \left(λ\right) L}$) since the distance *L* is very short. A long FSR of the interference signal can be discriminated from measurement signal.

The relatively small aperture 35 of the emitter 31 results in a diffracted beam. For a VCSEL, the divergence angle can be written as ${θ}_{FWHM} = 2 \sqrt{ln \left(2\right)} arctan \left(\frac{λ}{π \frac{{D}_{TJ}}{2}}\right)$ where *D_{TJ}* is the diameter of the tunnel junction and *λ* is the wavelength of the laser light. The larger the divergence the larger spherical aberrations at the outer surface of the ball lens. Those aberrations can be reduced by applying an index-matching glue (refractive index *n*(*λ*) close to that of the lens material) which reduces the divergence angle to: ${θ}_{FWHM} = 2 \sqrt{ln \left(2\right)} arctan \left(\frac{λ}{π \frac{{D}_{TJ}}{2} n \left(λ\right)}\right)$

For comparison, Fig. 3 shows a light source 80 comprising an emitter 81 and a single optical element 82 for beam shaping. Hence, in comparison to Fig. 2, the light source 80 shown in Fig. 3 does not comprise a combination of a first optical element as a micro-lens mounted directly over an aperture of the emitter and adapted to provide pre-collimated light to a second optical element that receives the pre-collimated light from the micro-lens and shapes a light beam for emission into the gas cell.

As can be seen from Fig. 3, a chief ray 83 and the respective marginal rays 84, 85 from the emitter 81 to the single optical element 82 have substantially different path lengths. Accordingly, a path length difference of a chief ray 83 and a marginal ray 84, 85 from the emitter 81 to the single optical element 82 may not allow for cancellation of disturbances in the signal processing, as for example described in the aforementioned US 9,377,359 B1, in view of the different path lengths onto different portions of the lens. In Fig. 3, the optical element 82 is illustrated as a beam shaping mirror. However, the problem of different path lengths also applies for a lens having an extended diameter.

Referring again to Fig. 2, this specific configuration can overcome the problem of a chief and marginal ray having substantially different path lengths such that residual disturbances cannot be cancelled in the signal processing. Since the second optical element having the much longer focal length is provided with pre-collimated light from the micro-lens and thus reduces a path length difference between the chief and marginal ray, interference mitigation in signal processing and adapting the (frequency) modulation depth of the emitter and the position of the second optical element with respect to each other becomes possible. The specific combination of a micro-lens 32 mounted directly over an aperture 35 of the emitter 31 and adapted to provide pre-collimated light in combination with a second optical element, wherein the ratio of the focal length f₂ of the second optical element to the focal length f₁ of the first optical element, f₂/f₁, of at least 20. Accordingly, the proposed solution can thus help to further improve the performance of devices for optical gas analysis.

The first optical element 32, here the ball lens, can reduce the beam divergence further to approx. 0.4° (HWHM, Half Width at Half Maximum), reducing the area of illumination on the second optical element, here an off-axis parabolic (OAP) mirror, significantly. Consequently, the distance between first optical element 32 and the regions of the second optical element 33 is now well defined and does not deviate significantly for the chief and marginal rays. This allows that the distance and/or a modulation span can be adjusted to a minimum of an interference filter curve, such that interference effects can be reduced.

Furthermore, the size or diameter of the second optical element 33, here of the OAP mirror, can be significantly reduced, as indicated by the dashed lines in Fig. 2. Hence, a much smaller OAP mirror 33' can be used. This has an impact on the fabrication cost of such a mirror. Since the OAP mirror as a high precision optical element is rather expensive, the cost reduction when using a smaller OAP mirror can even overcompensate the additional effort for providing the additional micro-lens. The mirror as the second optical element 33 can be an adjustable mirror for adjusting a direction of the light beam 60 for emission into the gas cell 20. Optionally, a separate mirror can be provided for adjusting a direction of the light beam for emission into the gas cell can be provided. An advantage of a separate mirror is that it can also be used with a lens as the second optical element. However, an additional synergistic effect can be reached if the second optical element is not only configured to provide the respective ratio of focal lengths but is further configured for adjusting the direction of the measurement light beam. For example, the number of passes in a multi-pass gas cell may be altered by adjusting the direction under which the light beam enters the gas cell. A position and/or tilt angle of the mirror may be adjustable.

It shall be understood that the working distance of the second beam shaping optical element relative to the emitter can be tailored to end up with the proper beam parameters, such as a desired beam divergence angle, according to the respective systems requirements, e.g. ending up with a collimated or focused beam for emission into the gas cell 20.

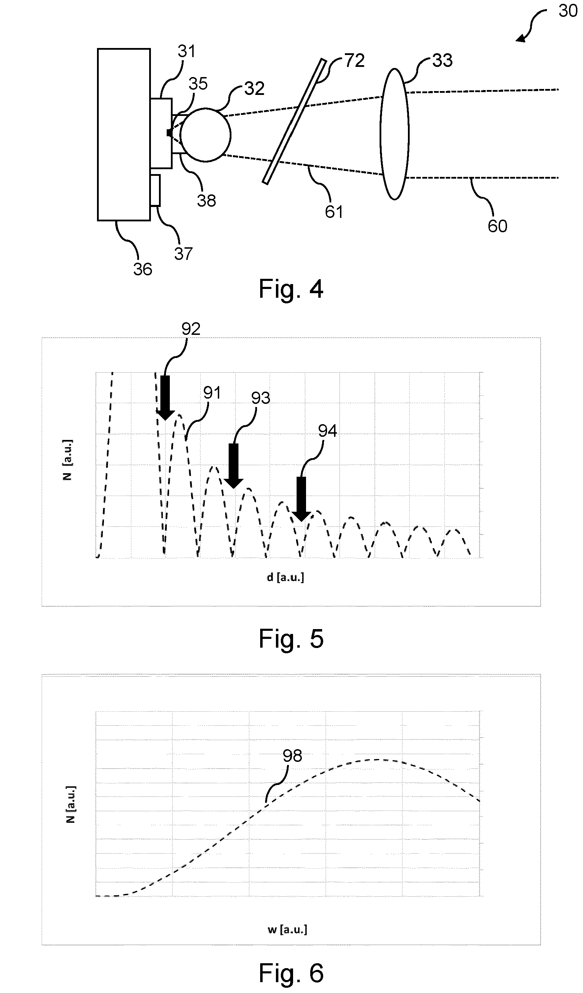

Fig. 4 shows a second exemplary embodiment of a light source 30 of a device 10 for optical gas analysis. Similar elements are denoted by the same reference numerals. Compared to the embodiment shown in Fig. 2, the second optical element 33 is implemented as a lens instead of an OAP mirror. In particular, the second optical element may be implemented as an optical thin lens as described above.

Fig. 5 shows a diagram illustrating an interference filter curve that can be seen as indicative of a noise contribution by direct feedback. Direct feedback noise can be due to light back-reflected from an optical surface onto or into the emitter. This may lead to (self-mixing) interference noise. The horizontal axis denotes the distance between the emitter 31 and the second optical element 33 (in arbitrary units, a.u.). The vertical axis denotes a noise contribution (in arbitrary units, a.u.). As can be seen from Fig. 5, the curve 91 features several distances at which a noise contribution becomes minimal. Referring to the minima, it is to be understood that the modulation span scans over an integer multiple of interference fringes. An extinction of interference effects occurs by the lock-in method at certain distances. It will be understood that the location of the minima depends on a frequency modulation span at which the emitter is modulated. The light emitter can be configured to emit light with a center wavelength λ0 and a modulation span Δλ. A distance between the second optical element and the light emitter and/or the light detector and the modulation span Δλ can be adapted with respect to each other such that a disturbance caused by an optical surface of the second optical element on a demodulated measurement signal is minimized. Accordingly, optical interference fringes caused from the second optical element 33 can be suppressed by a well-defined path length of the pre-collimated light received from the micro-lens, wherein the distance is selected to efficiently suppress interference fringes in the filter function shown in Fig. 5. For example, the exit window 72 may be positioned at a minimum indicated by reference numeral 92 and the second optical element may be positioned at a minimum indicated by reference numeral 93 or 94.

Residual optical interference fringes from the micro-lens, e.g. when using index matching glue only from an outer side of the ball lens, are suppressed by a very short focal length that ensures that residual optical noise exhibits a very long free-spectral range that can be well distinguished from the absorption signal.

Advantageously, referring again to the example of Fig. 2, there are just two optical active beam-shaping surfaces involved. The first optical beam-shaping surface is the outer side of the first beam shaping optical element which is glued with an index-matching glue onto the laser aperture. The second beam-shaping surface belongs to the second optical element, which can be implemented as a mirror with a reflective surface. Furthermore, when using an OAP mirror, the off-axis characteristics of the OAP mirror ensures that back-reflected light towards the laser is minimized.

Fig. 6 shows a diagram illustrating an interference filter curve indicative of a noise contribution due to lens thickness. The horizontal axis denotes lens thickness or width between the front and back surface of the lens (in arbitrary units, a.u.). The vertical axis denotes a noise contribution (in arbitrary units, a.u.). As can be seen from Fig. 6, curve 98, a noise contribution can be substantially reduced when using an optically thin lens. In view of the specific combination of providing a first optical element being a micro-lens mounted directly over an aperture of the emitter and adapted to reduce a divergence angle of light emitted by the emitter to provide pre-collimated light, in combination with a second optical element adapted to receive the pre-collimated light from the micro-lens and to shape a light beam for emission into the gas cell, wherein a ratio of the focal length f₂ of the second optical element to the focal length f₁ of the first optical element, f₂/f₁, is at least 20, the lens thickness of the second optical element, when implemented as a lens instead of a mirror, may be reduced further. Hence, the noise contribution can be advantageously reduced, thereby improving the sensitivity to low gas concentrations.

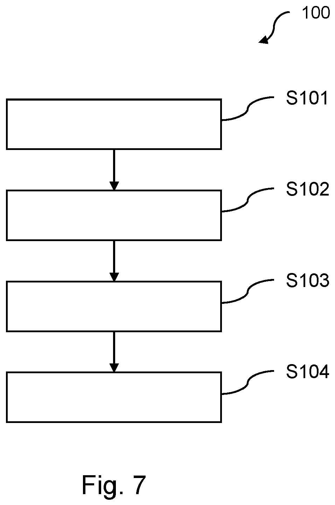

Fig. 7 shows a flow chart of a method 100 for optical gas analysis according to an aspect of the present disclosure. In a first step S101, a gas cell with a measurement gas is provided. In a second step S102 light from a light source is emitted into the gas cell. In a third step S103, the light is detected after passing through the measurement gas in the gas cell. In step S104, at least one gas concentration of at least one component of the measurement gas is determined based on the detected light. The light source comprises an emitter, a first optical element and a second optical element. The first optical element is a micro-lens mounted directly over an aperture of the emitter and adapted to reduce a divergence angle of light emitted by the emitter to provide pre-collimated light. The second optical element is adapted to receive the pre-collimated light from the micro-lens and to shape a light beam for emission into the gas cell, wherein a ratio of the focal length f₂ of the second optical element to a focal length f₁ of the first optical element, f₂/f₁, is at least 20.

In conclusion, a further improved device, system and method for optical gas analysis are provided that can help to further improve a measurement accuracy and/or sensitivity, while at the same time allowing reasonable costs. In contrast to a conventional approach, the proposed solution may result in a design with strongly reduced optical interferences. In an embodiment, this is made possible by a first lens with a very short focal length (for example f₁ <0.4mm, <0.6mm, <0.8mm) which allows a very short working distance to the laser. The short working distance results in an optical noise characteristic which hardly interferes with the measurement signal. The disadvantage, resulting from the short focal length lens is compensated by adding another beam shaping element which exhibits a much larger focal length than the first element, wherein a ratio of the focal length f₂ of the second optical element to the focal length f₁ of the first optical element, f₂/f₁, is at least 20 (for example f₂>10mm, >20mm, >30mm, >50mm). This allows for increasing the beam diameter which in turn enables small divergence angles to be realized. Since the beam parameter product (BPP) is constant, widening the beam allows for a smaller divergence. The reduction of the beam divergence with the help of the first lens allows for realizing a defined beam path length for the different rays to the second beam forming element, which enables an efficient noise suppression by filtering. In an advantageous refinement, there are just two optical active surfaces involved.

While the invention has been illustrated and described in detail in the drawings and foregoing description, such illustration and description are to be considered illustrative or exemplary and not restrictive; the claimed invention is defined by the appended claims and is not limited to the disclosed embodiments. Other variations to the disclosed embodiments, within the scope of the appended claims, can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. A single element or other unit may fulfill the functions of several items recited in the claims. The mere fact that certain measures are recited in mutually different dependent claims does not indicate that a combination of these measures cannot be used to advantage.

Any reference signs in the claims should not be construed as limiting the scope.

## Claims

1. Device (10) for optical gas analysis, the device comprising:
- a gas cell (20) for a measurement gas (21);
- a light source (30) adapted to emit light into the gas cell (20);
- a light detector (40) adapted to receive the light after passing through the measurement gas in the gas cell;
wherein the light source (30) comprises an emitter (31), a first optical element (32) and a second optical element (33);
- wherein the first optical element (32) is a micro-lens mounted directly over an aperture (35) of the emitter (31) and adapted to reduce a divergence angle of light emitted by the emitter to provide pre-collimated light (61);
- wherein the second optical element (33) is adapted to receive the pre-collimated light (61) from the micro-lens and to shape a light beam (60) for emission into the gas cell (20), wherein a ratio of the focal length f₂ of the second optical element (33) to a focal length f₁ of the first optical element (32), f₂/f₁, is at least 20.

2. Device for optical gas analysis according to claim 1, wherein a ratio of the focal length f₂ of the second optical element (33) to a focal length f₁ of the first optical element (32), f₂/f₁, is at least 35, in particular at least 50, in particular at least 100, in particular at least 150.

3. Device for optical gas analysis according to any of the preceding claims, wherein the micro-lens is adapted to reduce a divergence angle of the light emitted by the emitter (31) by at least 70 %, in particular by at least 80 %, in particular by at least 90 %.

4. Device for optical gas analysis according to any of the preceding claims, wherein the first focal length f₁ of the micro-lens is smaller than 0.8 mm, in particular smaller than 0.6 mm, in particular smaller than 0.4 mm, in particular smaller than 0.3 mm, in particular smaller than 0.2 mm.

5. Device for optical gas analysis according to any of the preceding claims, wherein the second focal length f₂ of the second optical element (33) is at least 10 mm, in particular at least 20 mm, in particular at least 30 mm, in particular at least 50 mm.

6. Device for optical gas analysis according to any of the preceding claims, wherein the second optical element (33) in the device for optical gas analysis is an optical thin lens.

7. Device for optical gas analysis according to any of the preceding claims, wherein the second optical element (33) in the device for optical gas analysis is an off-axis parabolic mirror.

8. Device for optical gas analysis according to any of the preceding claims, wherein the micro-lens is a ball lens mounted directly over the aperture (35) of the emitter (31) with index-matching glue (38), wherein a refractive index of the index matching glue matches a refractive index of the micro-lens.

9. Device for optical gas analysis according to any of the preceding claims, wherein the micro-lens is mounted directly over the aperture (35) of the emitter (31) in an index-matching manner; and wherein the second optical element (33) is a mirror.

10. Device for optical gas analysis according to any of the preceding claims, wherein the light emitter (31) and the first optical element (32) are arranged in a common light emitter housing (71), wherein the light emitter housing comprises an exit window (72) for the pre-collimated light (61), wherein the exit window is arranged in a light path between the first optical element (32) and the second optical element (33).

11. Device for optical gas analysis according to any of the preceding claims, wherein a position of the second optical element (33) with respect to the light emitter (31) is adapted to reduce an interference caused by an optical surface of the second optical element (33) to the light emitter (31).

12. Device for optical gas analysis according to any of the preceding claims,
wherein the light emitter (31) is configured to emit light with a center wavelength λ0 and a modulation span Δλ,
wherein a distance between the second optical element (33) and the light emitter (31) and/or the light detector (40) and the modulation span Δλ are adapted with respect to each other such that a disturbance caused by an optical surface of the second optical element (33) on a demodulated measurement signal is minimized.

13. Device for optical gas analysis according to any of the preceding claims, wherein the gas cell (20) is a multi-pass gas cell, in particular a multi-pass gas cell adapted to provide an optical path length of at least 5 m, in particular of at least 10 m, in particular of at least 20 m.

14. System (1) for optical gas analysis, the system comprising:
- a device (10) as claimed in any of the preceding claims; and
- an analyzer (50), wherein the analyzer is adapted to determine at least one gas concentration of at least one component of the measurement gas (21) based on the light detected by the light detector (40).

15. A method (100) for optical gas analysis, the method comprising the steps of:
- providing a gas cell with a measurement gas (S101);
- emitting light from a light source into the gas cell (S102);
- detecting the light after passing through the measurement gas in the gas cell (S103); and
- determining at least one gas concentration of at least one component of the measurement gas based on the detected light (S104);
wherein the light source comprises an emitter, a first optical element and a second optical element;
- wherein the first optical element is a micro-lens mounted directly over an aperture of the emitter and adapted to reduce a divergence angle of light emitted by the emitter to provide pre-collimated light;
- wherein the second optical element is adapted to receive the pre-collimated light from the micro-lens and to shape a light beam for emission into the gas cell, wherein a ratio of the focal length f₂ of the second optical element to a focal length f₁ of the first optical element, f₂/f₁, is at least 20.

## Patentansprüche

1. Vorrichtung (10) zur optischen Gasanalyse, wobei die Vorrichtung folgendes aufweist:
- eine Gaszelle (20) für ein Messgas (21);
- eine Lichtquelle (30), die dazu eingerichtet ist, Licht in die Gaszelle (20) zu emittieren;
- einen Lichtdetektor (40), der dazu eingerichtet ist, das Licht nach Passieren durch das Messgas in der Gaszelle zu empfangen;
wobei die Lichtquelle (30) einen Emitter (31), ein erstes optisches Element (32) und ein zweites optisches Element (33) aufweist;
- wobei das erste optische Element (32) eine Mikrolinse ist, die direkt über einer Apertur (35) des Emitters (31) montiert ist und dazu eingerichtet ist, einen Divergenzwinkel von durch den Emitter emittiertem Licht zu verringern, um vorkollimiertes Licht (61) bereitzustellen;
- wobei das zweite optische Element (33) dazu eingerichtet ist, das vorkollimierte Licht (61) von der Mikrolinse zu empfangen und einen Lichtstrahl (60) zur Emission in die Gaszelle (20) zu formen, wobei ein Verhältnis der Brennweite f₂ des zweiten optischen Elements (33) zu einer Brennweite f₁ des ersten optischen Elements (32), f₂/f₁, mindestens 20 beträgt.

2. Vorrichtung zur optischen Gasanalyse nach Anspruch 1, wobei ein Verhältnis der Brennweite f₂ des zweiten optischen Elements (33) zu einer Brennweite f₁ des ersten optischen Elements (32), f₂/f₁, mindestens 35, insbesondere mindestens 50, insbesondere mindestens 100, insbesondere mindestens 150 beträgt.

3. Vorrichtung zur optischen Gasanalyse nach einem der vorhergehenden Ansprüche, wobei die Mikrolinse eingerichtet ist, einen Divergenzwinkel des durch den Emitter (31) emittierten Lichts um mindestens 70 %, insbesondere um mindestens 80 %, insbesondere um mindestens 90 % zu reduzieren.

4. Vorrichtung zur optischen Gasanalyse nach einem der vorhergehenden Ansprüche, wobei die erste Brennweite f₁ der Mikrolinse kleiner als 0,8 mm, insbesondere kleiner als 0,6 mm, insbesondere kleiner als 0,4 mm, insbesondere kleiner als 0,3 mm, insbesondere kleiner als 0,2 mm ist.

5. Vorrichtung zur optischen Gasanalyse nach einem der vorhergehenden Ansprüche, wobei die zweite Brennweite f₂ des zweiten optischen Elements (33) mindestens 10 mm, insbesondere mindestens 20 mm, insbesondere mindestens 30 mm, insbesondere mindestens 50 mm ist.

6. Vorrichtung zur optischen Gasanalyse nach einem der vorhergehenden Ansprüche, wobei das zweite optische Element (33) in der Vorrichtung zur optischen Gasanalyse eine optische dünne Linse ist.

7. Vorrichtung zur optischen Gasanalyse nach einem der vorhergehenden Ansprüche, wobei das zweite optische Element (33) in der Vorrichtung zur optischen Gasanalyse ein Off-Axis-Parabolspiegel ist.

8. Vorrichtung zur optischen Gasanalyse nach einem der vorhergehenden Ansprüche, wobei die Mikrolinse eine Kugellinse ist, die direkt über der Apertur (35) des Emitters (31) mit einem indexangepassten Klebstoff (38) montiert ist, wobei ein Brechungsindex des indexantepassten Klebestoffs an einen Brechungsindex der Mikrolinse angepasst ist.

9. Vorrichtung zur optischen Gasanalyse nach einem der vorhergehenden Ansprüche, wobei die Mikrolinse direkt über der Apertur (35) des Emitters (31) in einer indexangepassten Weise montiert ist; und wobei das zweite optische Element (33) ein Spiegel ist.

10. Vorrichtung zur optischen Gasanalyse nach einem der vorhergehenden Ansprüche, wobei der Lichtemitter (31) und das erste optische Element (32) in einem gemeinsamen Lichtemittergehäuse (71) angeordnet sind, wobei das Lichtemittergehäuse ein Austrittsfenster (72) für das vorkollimierte Licht (61) aufweist, wobei das Austrittsfenster in einem Lichtpfad zwischen dem ersten optischen Element (32) und dem zweiten optischen Element (33) angeordnet ist.

11. Vorrichtung zur optischen Gasanalyse nach einem der vorhergehenden Ansprüche, wobei eine Position des zweiten optischen Elements (33) in Bezug auf den Lichtemitter (31) dazu eingerichtet ist, eine durch eine optische Oberfläche des zweiten optischen Elements (33) am Lichtemitter (31) verursachte Interferenz zu verringern.

12. Vorrichtung zur optischen Gasanalyse nach einem der vorhergehenden Ansprüche,
wobei der Lichtemitter (31) dazu eingerichtet ist, Licht mit einer zentralen Wellenlänge λ0 und einem Modulationsspanne Δλ zu emittieren,
wobei ein Abstand zwischen dem zweiten optischen Element (33) und dem Lichtemitter (31) und/oder dem Lichtdetektor (40) und die Modulationsspanne Δλ in Bezug zueinander derart angepasst sind, dass eine durch eine optische Oberfläche des zweiten optischen Elements (33) auf ein demoduliertes Messsignal verursachte Störung minimiert wird.

13. Vorrichtung zur optischen Gasanalyse nach einem der vorhergehenden Ansprüche, wobei die Gaszelle (20) eine Multipass-Gaszelle ist, insbesondere eine Multipass-Gaszelle, die dazu eingerichtet ist, eine optische Pfadlänge von mindestens 5 m, insbesondere von mindestens 10 m, insbesondere von mindestens 20 m bereitzustellen.

14. System (1) zur optischen Gasanalyse, wobei das System folgendes aufweist:
- eine Vorrichtung (10) nach einem der vorhergehenden Ansprüche; und
- einen Analysator (50), wobei der Analysator dazu eingerichtet ist, mindestens eine Gaskonzentration mindestens einer Komponente des Messgases (21) basierend auf dem durch den Lichtdetektor (40) detektierten Licht zu bestimmen.

15. Verfahren (100) zur optischen Gasanalyse, wobei das Verfahren die folgenden Schritte aufweist:
- Bereitstellen einer Gaszelle mit einem Messgas (S101);
- Emittieren von Licht aus einer Lichtquelle in die Gaszelle (S102);
- Detektieren des Lichts nach Passieren durch das Messgas in der Gaszelle (S103); und
- Bestimmen mindestens einer Gaskonzentration mindestens einer Komponente des Messgases basierend auf dem detektierten Licht (S104);
wobei die Lichtquelle einen Emitter, ein erstes optisches Element und ein zweites optisches Element aufweist;
- wobei das erste optische Element eine Mikrolinse ist, die direkt über einer Apertur des Emitters montiert ist und eingerichtet ist, einen Divergenzwinkel von durch den Emitter emittiertem Licht zu verringern, um vorkollimiertes Licht bereitzustellen;
- wobei das zweite optische Element dazu eingerichtet ist, das vorkollimierte Licht von der Mikrolinse zu empfangen und einen Lichtstrahl zur Emission in die Gaszelle zu formen, wobei ein Verhältnis der Brennweite f₂ des zweiten optischen Elements zu einer Brennweite f₁ des ersten optischen Elements, f₂/f₁, mindestens 20 beträgt.

## Revendications

1. Dispositif (10) permettant l'analyse optique de gaz, le dispositif comprenant :
- une cellule à gaz (20) pour un gaz de mesure (21) ;
- une source de lumière (30) apte à émettre de la lumière dans la cellule à gaz (20) ;
- un détecteur de lumière (40) adapté pour recevoir la lumière après son passage à travers le gaz de mesure dans la cellule à gaz ;
dans lequel la source de lumière (30) comprend un émetteur (31), un premier élément optique (32) et un second élément optique (33) ;
- dans lequel le premier élément optique (32) est une microlentille montée directement au-dessus d'une ouverture (35) de l'émetteur (31) et conçue pour réduire un angle de divergence de la lumière émise par l'émetteur pour fournir une lumière pré-collimatée (61) ;
- dans lequel le second élément optique (33) est conçu pour recevoir la lumière pré-collimatée (61) provenant de la microlentille et pour mettre en forme un faisceau lumineux (60) pour une émission dans la cellule à gaz (20), dans lequel un rapport de la longueur focale f₂ du second élément optique (33) sur une longueur focale f₁ du premier élément optique (32), f₂/f₁, est d'au moins 20.

2. Dispositif d'analyse optique de gaz selon la revendication 1, dans lequel un rapport de la longueur focale f₂ du second élément optique (33) sur une longueur focale f₁ du premier élément optique (32), f₂/f₁, est d'au moins 35, en particulier d'au moins 50, en particulier d'au moins 100, en particulier d'au moins 150.

3. Dispositif d'analyse optique de gaz selon l'une quelconque des revendications précédentes, dans lequel la microlentille est conçue pour réduire un angle de divergence de la lumière émise par l'émetteur (31) d'au moins 70 %, en particulier d'au moins 80 %, en particulier d'au moins 90 %.

4. Dispositif d'analyse optique de gaz selon l'une quelconque des revendications précédentes, dans lequel la première longueur focale f₁ de la microlentille est inférieure à 0,8 mm, en particulier inférieure à 0,6 mm, en particulier inférieure à 0,4 mm, en particulier inférieure à 0,3 mm, en particulier inférieure à 0,2 mm.

5. Dispositif d'analyse optique de gaz selon l'une quelconque des revendications précédentes, dans lequel la seconde longueur focale f₂ du second élément optique (33) est d'au moins 10 mm, en particulier d'au moins 20 mm, en particulier d'au moins 30 mm, en particulier d'au moins 50 mm.

6. Dispositif d'analyse optique de gaz selon l'une quelconque des revendications précédentes, dans lequel le second élément optique (33) dans le dispositif d'analyse optique de gaz est une lentille optique mince.

7. Dispositif d'analyse optique de gaz selon l'une quelconque des revendications précédentes, dans lequel le second élément optique (33) dans le dispositif d'analyse optique de gaz est un miroir parabolique hors axe.

8. Dispositif d'analyse optique de gaz selon l'une quelconque des revendications précédentes, dans lequel la microlentille est une lentille boule montée directement au-dessus de l'ouverture (35) de l'émetteur (31) avec une colle d'adaptation d'indice (38), dans lequel un indice de réfraction de la colle d'adaptation d'indice s'adapte à un indice de réfraction de la microlentille.

9. Dispositif d'analyse optique de gaz selon l'une quelconque des revendications précédentes, dans lequel la microlentille est montée directement au-dessus de l'ouverture (35) de l'émetteur (31) avec adaptation d'indice ; et dans lequel le second élément optique (33) est un miroir.

10. Dispositif d'analyse optique de gaz selon l'une quelconque des revendications précédentes, dans lequel l'émetteur de lumière (31) et le premier élément optique (32) sont agencés dans un boîtier d'émetteur de lumière commun (71), dans lequel le boîtier d'émetteur de lumière comprend une fenêtre de sortie (72) pour la lumière pré-collimatée (61), dans lequel la fenêtre de sortie est agencée dans un trajet lumineux entre le premier élément optique (32) et le second élément optique (33).

11. Dispositif d'analyse optique de gaz selon l'une quelconque des revendications précédentes, dans lequel une position du second élément optique (33) par rapport à l'émetteur de lumière (31) est conçue pour réduire une interférence causée par une surface optique du second élément optique (33) sur l'émetteur de lumière (31).

12. Dispositif d'analyse optique de gaz selon l'une quelconque des revendications précédentes,
dans lequel l'émetteur de lumière (31) est configuré pour émettre de la lumière avec une longueur d'onde centrale λ0 et une plage de modulation Δλ,
dans lequel une distance entre le second élément optique (33) et l'émetteur de lumière (31) et/ou le détecteur de lumière (40) et la plage de modulation Δλ sont adaptées l'une par rapport à l'autre de telle sorte qu'une perturbation causée par une surface optique du second élément optique (33) sur un signal de mesure démodulé est minimisée.

13. Dispositif d'analyse optique de gaz selon l'une quelconque des revendications précédentes, dans lequel la cellule à gaz (20) est une cellule à gaz à passages multiples, en particulier une cellule à gaz à passages multiples adaptée pour fournir une longueur de trajet optique d'au moins 5 m, en particulier d'au moins 10 m, en particulier d'au moins 20 m.

14. Système (1) permettant l'analyse optique de gaz, le système comprenant :
- un dispositif (10) selon l'une quelconque des revendications précédentes ; et
- un analyseur (50), dans lequel l'analyseur est conçu pour déterminer au moins une concentration de gaz d'au moins un composant du gaz de mesure (21) sur la base de la lumière détectée par le détecteur de lumière (40).

15. Procédé (100) permettant l'analyse optique de gaz, le procédé comprenant les étapes consistant à :
- fournir à une cellule à gaz un gaz de mesure (S101) ;
- émettre une lumière à partir d'une source de lumière dans la cellule à gaz (S102) ;
- détecter la lumière après son passage à travers le gaz de mesure dans la cellule à gaz (S103) ; et
- déterminer au moins une concentration de gaz d'au moins un composant du gaz de mesure sur la base de la lumière détectée (S104) ;
dans lequel la source de lumière comprend un émetteur, un premier élément optique et un second élément optique ;
- dans lequel le premier élément optique est une microlentille montée directement au-dessus d'une ouverture de l'émetteur et conçue pour réduire un angle de divergence de la lumière émise par l'émetteur afin de fournir une lumière précollimatée ;
- dans lequel le second élément optique est conçu pour recevoir la lumière pré-collimatée provenant de la microlentille et pour mettre en forme un faisceau lumineux pour une émission dans la cellule à gaz, dans lequel un rapport de la longueur focale f₂ du second élément optique sur une longueur focale f₁ du premier élément optique, f₂/f₁, est d'au moins 20.
